# EUROPÄISCHE PATENTANMELDUNG

(11) **EP 1 217 655 A1**
(43) Veröffentlichungstag der Anmeldung: **26.06.2002**
(21) Anmeldenummer: 00128491.8
(22) Anmeldetag: 23.12.2000
(51) Int. Cl.: H01L 21/68

(54) **Methode zur Handhabung dünner Wafer**

(71) Anmelder: VenTec Gesellschaft für Venturekapital und Unternehmensberatung, 57078 Siegen (DE)
(72) Erfinder: Arlt, Joachim, Dr., 57250 Netphen (DE); Busse, Karl-Hermann, Prof. Dr., 57234 Wilnsdorf (DE)

(57) **Zusammenfassung**

Es wird ein Verfahren zur, Handhabung von vorzugsweise dünnen Wafern, typischerweise dünner 200 µm, beschrieben. Die Wafer werden vor dem Schleifen oder bei einem weiteren Bearbeitungsschritt zum Dünnen auf einen transportablen elektrostatischen Halter (Substrathalter) aufgebracht. Die Wafer verbleiben für die Dauer und zwischen mindestens zwei Bearbeitungsschritten, während der, dazu gehörigen Handhabungsschritte und während einer' eventuell notwendigen Zwischenlagerung auf dem transportablen elektrostatischen Halter (Substrathalter), hier Transfer-ESC genannt. Dadurch wird die Gefahr des Waferbruchs vermindert und damit die Ausbeute der Bauelemente wesentlich erhöht. Das komplette Handhabungssystem besteht aus einem oder mehreren transportablen elektrostatischen Haltern (Substrathaltem) und einer oder mehreren Übergabestationen für die Wafer. Diese Übergabestationen, welche sich in und außerhalb der verschiedenen Beärbeitungs- bzw. Behandlungsstationen befinden können, dienen insbesondere dem elektrischen Auf- und Entladen der transportablen elektrostatischen Halter. Dieses komplette Handhabungssystem ist so ausgelegt, dass der mit dem Wafer verbundene Transfer-ESC mit nicht oder nur wenig modifizierten Handhabungseinrichtungen in Standardmaschinen zur Bearbeitung und Behandlung von Halbleitersubstraten eingesetzt werden kann.

## Beschreibung

Elektrostatische Haltesysteme sind seit längerem bekannt und in zahlreichen Patenten beschrieben. Der Stand der Technik ist mit Hinweisen auf die Patentliteratur in den folgenden Übersichtsartikeln dargelegt. Dies sind Shermann et al.: Semiconductor International V 20 July 1997, 319-321; Olsen et al.: Rev Sci. Instrum. 66 (2) Feb. 1995, 1108-14; Watanabe et al. Jpn. J. Appl. Phys. Vol (32) 1993, 864-71; Hartsough Solid State Technol., 97 (1) 1994, 91 - 98. Danach ist das Fixieren von Halbleitersubstraten (Wafern) mit elektrostatischen Haltevorrichtungen in Maschinen zur Behandlung von Wafern Stand der Technik. Dabei werden die Wafer aber nach Ende eines jeden Prozessschrittes von dem elektrostatischen Haltesystem gelöst.
Auch das Transferieren von Wafern mit elektrostatischen Haltesystemen von und auf wie auch immer gearteten Substrathaltern wurde schon verschiedentlich beschrieben, siehe oben Shermann et al. Allen diesen Vorrichtungen ist jedoch gemein, dass der Wafer nur während eines Prozess- oder Handhabungsschrittes mit dem elektrostatischen Haltesystem, innerhalb einer Bearbeitungsmaschine verbunden bleibt.
Systeme dieser Art erfüllen alle in sie gesetzten Anforderungen, zumindest was die Handhabung betrifft, bei Wafem der Standarddicken (ca. 750 µm) bis hin zu gedünnten Wafem von ca. 200 µm. Bei Dicken von ca. 200 µm bis ca. 100 µm allerdings nur solange, wie der Wafer zusätzlich, mit einem aufgeklebten Kunststofffilm (Tape), verstärkt wird. Eine weitere Schwierigkeit besteht darin, dass dünne, geschliffene Wafer extrem bruchempfindlich sind, solange die vom Schleifen herrührenden Defekte nicht durch ein nasses oder trockenes Entspannungsätzen entfernt sind.
Bei Wafern, die unter ca. 100 µm dick sind (die technische Grenze liegt zur Zeit bei bis rd. 20 µm Dicke) ist es Stand der Technik, dass die Wafer durch Kleben (Wachs, doppelseitiger Kunststoffilm, - Tape -, reiner Kleber) oder sogar Löten auf einen starren Träger aufgebracht werden müssen, um die Bruchgefahr und das erhebliche Durchbiegen der entspannten Wafer zu reduzieren.
Diese Verfahren können aber nicht befriedigen, weil bis auf das Löten die Temperaturstabilität der Verbindung zu niedrig und bei allen Verfahren das Lösen der dünnen Wafer vom Träger technisch sehr aufwendig und problembehaftet hinsichtlich der Bruchgefahr ist. Eine Ausnahme bildet hier lediglich die Verwendung von Klebern, die nach UV- Belichtung ihre Klebekraft fast vollständig verlieren. Diese sind aber zur Zeit nicht höher als rd. 80°C temperaturbeständig.
Einen eleganten Ausweg aus dieser Problematik bietet die Verwendung eines transportablen, elektrostatischen Halters (Substrathalters), in dieser Schrift Transfer-ESC genannt. Auf diesen wird der Wafer aufgebracht und verbleibt während des Dünnens des Wafers für einige oder alle weiteren Prozessschritte (Bearbeitungsschritte, Handhabungsschritte, Zwischenlagerung), z.B. bis zum Separieren der einzelnen Bauelemente oder dem Abnehmen der Bauelemente oder Wafer zum Verpacken , auf dem Transfer-ESC.
Mit einem solchen Transfer-ESC ist man in der Lage, auch einen sehr dünnen Wafer (< 50 µm) unproblematisch zu handhaben und zu transportieren. Im Unterschied zu den anderen Verfahren, wie Kleben, ist der Wafer auch leicht durch den Aufbau elektrostatischer Haltekraft (elektrisches Aufladen) zu fixieren und von dem Transfer-ESC durch den Abbau elektrostatischer Haltekraft (elektrisches Endladen) zu lösen.
Zusätzliche Reinigungsschritte oder ähnliche Behandlungen der Wafer zum Entfernen von Klebern oder Folien sind hierbei nicht erforderlich.
Ein für eine solche Aufgabe geeigneter transportabler elektrostatischer Halter muss die folgenden Anforderungen ganz oder teilweise erfüllen:
Die Haltekraft muss ähnlich hoch sein wie bei den üblicherweise in Schleifmaschinen zum Waferdünnen zum Fixieren von Wafern genutzten Vakuumhaltern (bis ca. 0,1N/mm²). Der elektrostatische Halter muss daher besonders wegen der hohen Scherkräfte beim Schleifprozess eine möglichst hohe Haltekraft besitzen.
Daher ist hier die Verwendung von unipolaren elektrostatischen Haltern das Verfahren der Wahl, wenn nicht andere Argumente, z. B. das schwierigere Laden und Entladen, erfordern bipolare elektrostatische Halter zu verwenden.
Das System muß seine elektrostatische Ladung ohne ständiges elektrisches Nachladen möglichst lange halten (einige Stunden), damit auch bei längeren oder mehreren Prozessschritten bzw. Behandlungsschritten der dünne Wafer sich nicht selbsttätig vom Transfer-ESC separiert.
Ferner muss der Transfer-ESC gegen Wasser und Säure resistent sein (z.B. beim Schleifen und dem Naßätzen).
Das System muss zudem extrem eben sein, weil sonst der Wafer beim Schleifen uneben wird.
Weiterhin muss dieser temperaturbeständig sein, idealerweise bis 450°C (z.B. beim Trocken- bzw. Plasmaätzen oder bei der Wärmebehandlung von Leistungshalbleitern).
Zudem sollte er möglichst dünn (möglichst dünner als 1 mm) und sehr leicht sein, um in vorhandenen Maschinen und Einrichtungen, die für dicke Wafer ohne Transfer-ESC ausgelegt sind, mit möglichst geringen Änderungen und ohne zusätzliche Investitionen handhabbar zu sein.
Damit der Transfer-ESC auch in einer teilweise nassen Umgebung betrieben werden kann, muss dieser zudem gut isoliert sein. Daher ist es nötig die Kontaktierungen (Hochspannungsanschlüsse) vor Feuchtigkeit zu schützen. Daher bietet es sich an, die elektrische Aufladung bzw. Entladung des Transfer-ESC's, z.B. durch induktive Einkopplung der Hochspannung berührungslos vorzunehmen. Der Transfer-ESC muss dann mit einer Gleichrichterschaltung versehen werden, um aus der eingekoppelten Wechselschaltung die benötigte Gleichspannung zu erzeugen. Es ist auch vorteilhaft, wenn der Transfer-ESC für längere Zeit unzugänglich ist, die komplette elektrische Lade- und Entladevorrichtung im Transfer-ESC zu integrieren und mittels einer Batterie bzw. eines Akkumulators elektrisch zu versorgen. Hierzu muss in den Transfer-ESC eine Wechselrichterschaltung und eine Kaskade von Spannungsvervielfachern und eine anschließende Gleichrichterschaltung integriert werden.
Falls erforderlich können die wesentlichen Funktionen als Transfer-ESC's, wie elektrostatisches Aufladen und elektrostatisches Entladen auch ferngesteuert werden.
Aufgrund der oben genannten Anforderungen bieten sich für das Dielektrikum des transportablen elektrostatischen Halters, neben Kunststofffilmen, vorzugsweise keramische Werkstoffe, z.B. Quarz, Glas, Aluminiumoxid, Titandioxid, Bariumtitanat an.
Die Verwendung von Keramiken hat zudem dem Vorteil, dass hierdurch hohe Dielektrizitätskonstanten bei geringer Dicke des Dielektrikums realisiert werden können. Hierdurch kann die Haltekraft der Transfer-ESC's, z.B. gegenüber Kunststoffen, um ein Vielfaches erhöht werden.

Zum Herstellen von sehr dünnen Transfer-ESC können auch die aus der Mikroelektronik bzw. Mikrostrukturtechnik bekannten Herstellverfahren (z.B. Lithographie, Plasmaätzen) und Abscheideverfahren (PVD-, CVD-Techniken) von
dielektrischen Werkstoffen auf Halbleitermaterialien, wie Silizium, verwendet werden

Der Transfer-ESC kann auch zur Produktionsverfolgung der einzelnen, gedünnten und daher sehr teuren Wafer mit elektronischen Labels versehen werden.
So lässt sich ein Wafer erzeugen der letztlich der geeignete transportable Transfer-ESC ist.

Das platzieren der Wafer auf dem Transfer-ESC, das Lagern der mit dem Wafer verbundenen Transfer-ESC's, das Nachladen des vorgenannten Verbundes und gegebenenfalls das Ablösen des Wafers vom Transfer-ESC erfolgt zweckmässigerweise in einem getrennten Gerät (hier bezeichnet als Übergabestation).

Kernkomponente der Übergabestation ist ein Probentisch, eventuell auch als elektrostatischer Halter ausgelegt, auf dem die Tansfer-ESC's positioniert werden.
Dann wird der Wafer auf dem Transfer-ESC abgelegt und durch Laden des Transfer-ESC's fixiert. Bei stark nichtplanen Wafern kann es erforderlich sein das Fixieren durch eine mechanische Belastung zu unterstützen. Wenn auf diesem Probentisch auch der Wafer von dem Transfer-ESC gelöst werden soll, muss er mit Sensoren versehen werden, die das Lösen des Wafers vom Transfer-ESC anzeigen.
Der zentrale Probentisch der Übergabestation wird von einem Roboter bedient, der die Wafer aus dem Carrier entnimmt und auf den Transfer-ESC auf dem Probentisch ablegt. Derselbe oder optimalerweise ein zweiter Roboter entnimmt die Tranfer-ESC's aus speziellen Horden und legt die beladenen ESC's in Horden oder speziellen Carriern ab.
Eine Möglichkeit ist das ein Roboter der Übergabestation den mit dem Wafer verbundenen Transfer-ESC direkt an die Bearbeitungsmaschinen weitergibt.
Damit kein Waferbruch bei der Übergabestation erfolgt, soll die jeweilige Waferübergabe mit optischen Lagesensoren (z.B. Laserlagesensoren) kontrolliert und überwacht werden.

Das komplette elektrostatische Handhabungssystem zum Transportieren und Handhaben, insbesondere von dünnen Wafern, besteht daher aus mehreren Transfer-ESC's und einer oder mehreren Übergabestationen.

Das hier beschriebene Verfahren und das elektrostatische Haltesystem und auch der beschriebene transportable elektrostatische Transfer-ESC bietet sich vorzugsweise für die Handhabung beim Dünnen von Wafern an.
Weitere Einsatzgebiete dieses Verfahrens und des Handhabungssystems sind überall da, wo sowohl aus ökonomischen als auch technischen Gegebenheiten das Verwenden von transportablen elektrostatischen Haltern, welche ohne ständiges stationäres elektrisches Nachladen über längere Zeit die elektrostatische Kraft aufrecht erhalten können, vorteilhaft ist. Beispielsweise ist die physikalischchemische Analytik von Wafem zu nennen.

So kann ein derartiges System zum Transport von Wafern in und aus einem Elektromikroskop (SEM) zur Waferanalyse verwendet werden.

Am folgenden Beispiel (Ablaufbeispiel Nr. 1 bis 7) soll nachfolgend das elektrostatische Handhabungsverfahren mit einem Transfer-ESC, insbesondere für dünne Wafer, erläutert werden.
1. Die vorher strukturierten dicken Wafer (Dicke ca. 200 bis 750 µm) werden in Carriem bzw. Waferboxen zum Dünnen angeliefert.
2: Ein Roboter entnimmt den dicken Wafer aus dem Carrier und legt ihn auf den Transfer-ESC.
3. Der Transfer-ESC wird elektrisch geladen und fixiert hierdurch den zu dünnenden Wafer.
   Anschließend wird der Transfer-ESC mit dem fixierten Wafer entweder in Carriern abgelegt oder direkt zum Dünnen in die weiteren Bearbeitungsmaschinen transportiert (z.B. Schleif-, Ätzmaschinen).
4. In bestimmten Zeitabständen (typischerweise 4 bis 8 Stunden) während, nach oder vor einer Bearbeitung wird der Transfer-ESC mit dem fixierten Wafer in oder außerhalb der Bearbeitungsmaschine, z.B. unter Zuhilfenahme einer, wie oben beschriebenen, weiteren Übergabestation nachgeladen.
5. Anschließend werden die nachgeladenen Transfer-ESC mit dem fixierten Wafer, z.B. zur nächsten Bearbeitungsmaschine gebracht oder in Carriern abgelegt.
6. Die vorgenannten Schritte 4 und 5 können sich je nach Länge der Prozessabläufe und Anzahl der Prozessschritte mehrfach wiederholen.
7. Nach dem Abschluss der jeweiligen Bearbeitungsprozesse (z.B. Dünnen, Sägen, Sortieren) oder falls erforderlich zwischendurch, wird der Transfer-ESC elektrisch entladen und gibt den dünnen Wafer bzw. die bereits getrennten Bauelemente zur weiteren Bearbeitung oder z. B. dem Verpacken frei.

## Patentansprüche

1. Ein Verfahren zur Handhabung von Halbleitersubstraten (Wafern), bei dem das Halbleitersubstrat auf einen transportablen elektrostatischen Halter aufgebracht wird und der Wafer für die Dauer und zwischen mindestens zwei Bearbeitungsschritten auf dem elektrostatischen Halter verbleibt.

2. Ein Verfahren nach Anspruch 1, bei dem der transportable elektrostatische Halter vorzugsweise eine Dicke von 0,3 bis 2,5 mm aufweist und so der mit dem Wafer beladene elektrostatische Halter in nicht oder wenig modifizierten Maschinen zur Bearbeitung von Halbleitersubstraten eingesetzt werden kann.

3. Ein Verfahren nach dem Anspruch 1, bei dem das elektrostatische Haltesystem kontaktlos induktiv aufgeladen und entladen werden kann.

4. Ein Verfahren nach Anspruch 1, bei dem der transportable elektrostatische Halter über eine integrierte elektrische Ladeeinrichtung und / oder Entladeeinrichtung verfügt, die von einer Batterie bzw. einem Akkumulator gespeist wird.

5. Ein Verfahren nach Anspruch 4, bei dem der transportable elektrostatische Halter zum elektrostatischen Aufladen und / oder zum elektrostatischen Entladen ferngesteuert wird.

6. Ein Verfahren nach Anspruch 1, bei dem das elektrische Aufladen und / oder elektrische Entladen des transportablen elektrostatischen Halters separat in einer oder mehreren mobilen oder stationären Übergabestationen erfolgt. Falls die Notwendigkeit besteht, kann auch die Möglichkeit vorgesehen werden, den elektrostatischen Halter in der Beladestation von den Bearbeitungsmaschinen nachzuladen oder zu entladen.

7. Ein Verfahren nach Anspruch 1, bei dem das Fixieren und / oder das Lösen der Wafer mittels Lagesensoren überwacht und / oder gesteuert wird.

8. Ein Verfahren nach Anspruch 1, bei dem der transportable elektrostatische Halter als unipolares oder bipolares elektrostatisches System ausgeführt ist.

9. Ein Verfahren nach Anspruch 1, bei dem der elektrostatische Halter mit einem elektronischen Label **gekennzeichnet ist**, um eine Sortierung und Produktionsverfolgung der einzelnen Wafer zu ermöglichen.
